# EUROPEAN PATENT SPECIFICATION

(11) **EP 2 674 517 B1**
(45) Date of publication and mention of the grant of the patent: **03.10.2018**
(21) Application number: 12744739.9
(22) Date of filing: 08.02.2012
(51) Int. Cl.: C30B 29/10, C01F 11/18, C30B 7/08

(54) **METHOD FOR PRODUCING CALCITE SINGLE CRYSTAL**
VERFAHREN ZUR HERSTELLUNG EINES CALCIT-EINKRISTALLS
PROCÉDÉ DE PRODUCTION D'UN MONOCRISTAL DE CALCITE

(30) Priority: 08.02.2011 JP 2011025329
(43) Date of publication of application: 18.12.2013
(73) Proprietor: Japan Agency for Marine-Earth Science and Technology, Yokosuka-shi Kanagawa 237-0061 (JP)
(72) Inventor: YANAGISAWA, Kazumichi, Kochi-shi, Kochi 780-8520 (JP); SAKAGUCHI, Arito, Yokosuka-shi, Kanagawa 237-0061 (JP); SAKAGUCHI, Hide, Yokosuka-shi, Kanagawa 237-0061 (JP)
(74) Representative: Müller-Boré & Partner Patentanwälte PartG mbB
(86) International application number: PCT/JP2012/052878
(87) International publication number: WO 2012/108473

(56) References cited:
- EP-A1- 0 288 221
- HIRANO S ET AL: "Synthetic calcite single crystals for optical device", PROGRESS IN CRYSTAL GROWTH AND CHARACTERIZATION OF MATERIALS, ELSEVIER PUBLISHING, BARKING, GB, vol. 23, 1 January 1992 (1992-01-01), pages 341-367, XP025748666, ISSN: 0960-8974, DOI: 10.1016/0960-8974(92)90027-N [retrieved on 1992-01-01]
- SHIN'ICHI HIRANO ET AL.: 'Hydrothermal Growth and Characterization of Calcite Single Crystals for Optical Device' REPORTS OF THE ASAHI GLASS FOUNDATION vol. 61, 1992, pages 1 - 16, XP008170976
- SHIN'ICHI HIRANO ET AL.: 'Hydrothermal Growth of Calcite Single Crystals in Nitrate Solutions' JOURNAL OF THE CERAMIC SOCIETY OF JAPAN vol. 101, no. 1, 1993, pages 113 - 117, XP000378217
- KAZUMICHI YANAGISAWA ET AL.: 'Hydrothermal Single Crystal Growth of Calcite in Organic Salt Solutions' DAI 36 KAI PROCEEDINGS OF THE INTERNATIONAL CONFERENCE ON HIGH PRESSURE SCIENCE AND TECHNOLOGY 08 November 1995, page 116, XP008170902
- KAZUMICHI YANAGISAWA ET AL.: 'Solubility Measurement and Single Crystal Growth of Calcite under Hydrothermal Conditions' DAI 38 KAI JINKO KESSHO TORONKAI KOEN YOSHISHU 30 September 1993, pages 49 - 50, XP008170982

## Description

### TECHNICAL FIELD

The present invention relates to a method for producing a calcite single crystal which is appropriately fine in a large scale with no difficulty.

### BACKGROUND ART

Calcite is a crystal of calcium carbonate and referred to as "houkaiseki" in Japanese as a mineral. Pure calcite is transparent, and calcite which is colored due to impurity is referred to as marble stone and used as a constructional material and the like. In addition, calcite which is colorless and transparent is used as an optical material, since calcite shows a birefringent effect.

As a special nature except for the above, it is demonstrated that when calcite is subjected to stress, a single crystal is changed to a bicrystal depending on the scale of the received stress. Through the use of such a nature of calcite, history of stress which is applied to a target substance is measured by using calcite in the invention described in Patent Document 1.

Specifically, for example, even if a large stress is applied to a concrete construction due to an earthquake or the like, in case that the construction is not broken but deformed only and then the original shape is returned due to the release of an external force, the size and distribution of the applied stress cannot be precisely measured. On the other hand, when calcite is added to concrete and the like, the added calcite is changed from a single crystal to a bicrystal in response to the received stress; therefore, a magnitude of the stress which is given to the construction can be estimated by observing the calcite crystal contained in a sample obtained from the construction and measuring an interstice of the bicrystal.

As described above, calcite is very useful. However, there are various types of natural calcite, and it is not always true that a certain kind of calcite which is suitable for a desired usage can be obtained in a large scale. Therefore, calcite is also artificially produced.

For example, the present inventors developed a method for producing a calcite single crystal and have a patent application of the method (Patent Document 2). In the method, a raw material calcite crystal debris is placed on a bottom part of a vertically long autoclave, a calcite crystal seed is suspended in a upper part of the autoclave, and a convection control board is placed in the interval. The bottom part is heated at a higher temperature than that of the upper part and the temperature is maintained. As a result, a larger amount of calcite is dissolved in the bottom part of the autoclave and the solution which is swelled and of which specific gravity becomes smaller is transferred to the upper part having a lower temperature due to heat convection through holes of the convection control board. In addition, calcite which is excessively dissolved in the solution is precipitated, since a temperature of the upper part is lower. Next, a solution of which specific gravity becomes smaller by cooling is returned to the bottom part. The above crystal seed is developed by the above-described material transfer due to heat convection.

### PRIOR ART

### PATENT DOCUMENT

Patent Document 1: JP 2008-286689 A
Patent Document 2: JP H10-259094 A

EP0288221 discloses a hydrothermal method of manufacturing calcium carbonate single crystals.

Hirano S et Al.: "Synthetic calcite single crystals for optical device" Progress in crystal growth and characterization of materials, Elsevier publishing, Barking, GB, vol. 23, 1 January 1992, pages 341-367, DOI: 10.1016/0960-8974(92)90027-N

### DISCLOSURE OF THE INVENTION

### PROBLEMS TO BE SOLVED BY THE INVENTION

As described above, a single crystal of calcite is usable as a stress sensor and the like, and a production method thereof has been developed.

However, the objective of the invention described in Patent Document 2 is to obtain a larger size calcite single crystal, since the crystal is used as optical materials such as an optical element material. Therefore, the method is not suitable for producing a fine calcite single crystal, which is used as a stress sensor or the like. On the other hand, when a too fine calcite single crystal is used as a stress sensor, it is difficult to find out such a crystal from a construction or the like. In addition, under the circumstance that an interstice of calcite bicrystal is determined depending on received stress, a lower detection limit becomes higher and a measurable range becomes smaller. Further, if an additive amount of calcite single crystal is increased or a larger size crystal is used to easily find out the crystal in a construction, there is a problem that strength of the construction is lowered.

Under the above-described circumstances, the objective of the present invention is to provide a method for producing a calcite single crystal which is appropriately fine in a large scale with no difficulty.

### MEANS FOR SOLVING THE PROBLEMS

The present inventors conducted intensive studies to solve the above problems. As a result, the present inventors found that the condition to obtain a calcite single crystal which is appropriately fine is very strict. For example, even when an amount of raw material calcium carbonate or pH of an aqueous solution as a solvent is slightly changed, the target single crystal cannot be obtained or the yield is extremely lowered. The present inventors further, investigated the condition and completed the present invention by finding that the above-described problem can be solved by appropriately adjusting the kind, concentration and pH of an aqueous solution used as a solvent, quantitative ratio of raw material calcium carbonate and the aqueous solution solvent, and heating temperature.

The method for producing a calcite single crystal according to the present invention is characterized in comprising the steps of mixing raw material calcium carbonate with an ammonium nitrate aqueous solution to obtain a raw material mixed liquid, wherein pH of the ammonium nitrate aqueous solution is not less than 7.0 and not more than 8.0, a concentration of the ammonium nitrate aqueous solution is not less than 2 M, and a concentration of calcium carbonate in the raw material mixed liquid is not less than 4 g/L and not more than 16 g/L; heating the raw material mixed liquid at not less than 125°C; and then gradually cooling the raw material mixed liquid at a cooling rate of not less than 0.5°C/h and not not more than 10°C/h; wherein the raw material mixed liquid is stirred at a stirring speed of not less than 80r/min and not more than 300 r/ min at least in the gradually cooling step.

The present invention method is particularly suitable for producing a calcite single crystal having a particle diameter of not less than 100 µm and not more than 1.5 mm. The calcite single crystal having a particle diameter included in the above range can be effectively used as a stress sensor, and the present invention method is suitable for producing such a calcite single crystal.

In the present invention method, the raw material mixed liquid is stirred at least in the gradually cooling step. The present inventors found that the condition to cool the raw material mixed liquid after heating is particularly important for uniformly growing a calcite single crystal as much as possible in an appropriate range. In addition, it is preferred that the cooling condition is uniformly applied to a whole of the raw material mixed liquid. Therefore, the raw material mixed liquid is stirred at least in the gradually cooling step at a stirring speed of not less than 80 r/min and not more than 300 r/min. The present inventors found that a diameter of the single crystal tends to be too small in both cases that a stirring speed during gradually cooling is too fast and too slow; on the other hand, when the stirring speed is set within the above range, a calcite single crystal having an appropriate particle diameter can be obtained.

It is preferred that a second heating step for heating the raw material mixed liquid to not less than 125°C after the gradually cooling step, i.e. a first gradually cooling step, and a second gradually cooling step for gradually cooling the raw material mixed liquid after the second heating step are carried out. When the above steps are carried out, a diameter of calcite single crystal can be increased in an appropriate range.

For the same purpose, it is preferred that a calcite single crystal having a particle diameter of not less than 100 µm is used as at least a part of the raw material calcium carbonate. Even if general calcium carbonate is completely dissolved in the heating step, such a calcite single crystal readily remains. The remaining crystal acts as a nucleus for recrystallization in the subsequent gradually cooling step, and a crystal which has high quality and appropriate size may be obtained more surely.

### EFFECT OF THE INVENTION

A fine calcite single crystal can be used for a stress sensor by mixing with a constructional material and the like. However, when a diameter of the crystal is too large in such a case, strength of a construction or the like is lowered. Therefore, a particle diameter of the crystal is preferably 1.5 mm or less. On the other hand, it is difficult to find out a too fine calcite single crystal from a construction sample. In addition, when such a too fine crystal is used, a lower detection limit becomes higher and a measurable range becomes smaller, since an interstice of a calcite bicrystal is determined by the received stress. Therefore, although it is certain that a fine calcite single crystal is suitable as a stress sensor, there is a limit to the smallness in terms of convenience.

Conventionally, since a calcite single crystal has been mainly used as an optical material due to specific optical properties, the condition to produce a larger crystal has been investigated but there has been no method for producing a crystal used as a stress sensor. On the other hand, according to the present invention method, a calcite single crystal which is appropriately fine and which can used as a stress sensor can be produced in a large scale with no difficulty. Therefore, the present invention is very useful, since it is possible by the present invention to industrially utilize a calcite single crystal as a stress sensor.

### BRIEF DESCRIPTION OF THE DRAWING

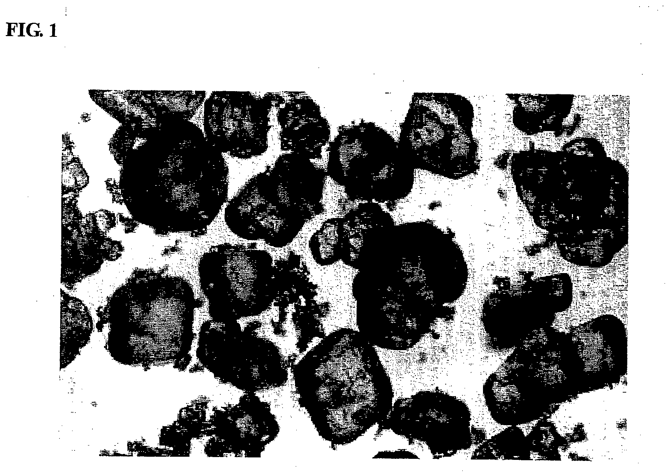

Figure 1 is a magnified photograph of the calcite single crystal produced by the present invention method.

### MODE FOR CARRYING OUT THE INVENTION

Hereinafter, the present invention method is described in the order of operation.

### (1) Step for preparing raw material mixed liquid

In the present invention method, an ammonium nitrate aqueous solution is used as a solvent to prepare a raw material mixed liquid. It is needed that the solution used in the present invention has a property to dissolve calcite at a high temperature and precipitate calcite at a low temperature. Pure water and the like cannot be used, since the solubility of calcite is low. On the other hand, an ammonium glutamate aqueous solution can dissolve a large amount of calcite at a high temperature; however, an ammonium glutamate aqueous solution cannot be used, since calcite cannot be precipitated from the solution even at a low temperature. An ammonium nitrate aqueous solution is very suitable for the above purpose.

A concentration of an ammonium nitrate aqueous solution may be appropriately adjusted in accordance with a relative amount of used calcium carbonate, and may be adjusted in a range of not less than 2 M and not more than 5 M. When the concentration is not less than 2 M, a calcite single crystal which is appropriately fine can be sufficiently produced. On the other hand, the upper limit is not particularly limited, but when the concentration is too high, an amount of needed ammonium nitrate is increased and cost rises. Therefore, the concentration is preferably not more than 5 M. The concentration is more preferably not less than 3 M.

A value of pH of an ammonium nitrate aqueous solution is preferably not less than 7.0 and not more than 8.0. When the pH is more than 8.0, a fine powder consisting of a too fine particle may be precipitated in a large amount and a calcite single crystal may not be obtained. Even if a calcite single crystal is obtained, the light permeability may be lowered. On the other hand, when the pH is lower than 7.0, the single crystal can be obtained, but the obtained single crystal may be small and the yield may be low. However, when the pH is adjusted to not less than 7.0 and not more than 8.0, a calcite single crystal which is appropriately fine can be produced with good yield.

The pH of an ammonium nitrate aqueous solution can be adjusted in accordance with a usual method. For example, the pH can be adjusted by adding ammonia in an appropriate amount, since the pH of an ammonium nitrate aqueous solution is usually about 5.

In the present invention method, raw material calcium carbonate is mixed with the above-described ammonium nitrate aqueous solution in order to obtain a raw material mixed liquid.

As raw material calcium carbonate, commercially available calcium carbonate ultrafine powder can be used. When a single crystal which has relatively large particle diameter is required, a calcite single crystal which is appropriately fine itself can be used as raw material calcium carbonate . A calcite single crystal which is appropriately fine is relatively difficult to be dissolved in comparison with commercially available calcium carbonate ultrafine powder, since a larger particle is relatively difficult to be dissolved in comparison with a smaller particle. If a calcite single crystal which is appropriately fine remains without completely being dissolved in the next heating step, the remaining crystal serves as a nucleus for recrystallization; as a result, a larger single crystal can be obtained.

A particle diameter of such a raw material calcite single crystal is preferably not less than 100 µm. When the diameter is not less than 100 µm, the single crystal may readily remain even after the heating step. Such a remaining single crystal serves as a nucleus for recrystallization in the subsequent gradually cooling step, and a superior crystal having an appropriate size may be obtained more surely. On the other hand, when the diameter is too large, the diameter of the finally obtained single crystal may be possibly larger than that suitable for a stress sensor. Therefore, the diameter is preferably not more than 1.2 mm. Even if too large single crystal is contained in a product, there is no problem as long as the productivity does not become problem, since such a too large crystal can be removed using a sieve or the like.

When a calcium carbonate ultrafine powder and a calcite single crystal which is appropriately fine are used in combination as raw material calcium carbonate, a ratio of a calcite single crystal relative to a calcium carbonate ultrafine powder is preferably not less than 0.5 times by mass. The ratio is not less than 0.5 times by mass, a superior crystal having an appropriate size may be effectively obtained more surely. On the other hand, a calcite single crystal may be used as all of raw material calcium carbonate; however, cost is raised in such a case. Therefore, the ratio is preferably not more than 5 times by mass.

A ratio of raw material calcium carbonate relative to an ammonium nitrate aqueous solution is preferably not less than 4 g/L and not more than 16 g/L. The yield or the like is dependent on a concentration of an ammonium nitrate aqueous solution; but when the ratio is included in the above range, a calcite single crystal which is appropriately fine may be produced with good yield more surely. The ratio is more preferably not less than 5.0 g/L and more preferably not more than 6.0 g/L, even more preferably not more than 5.75 g/L, and particularly preferably not more than 5.5 g/L. When a temperature of a mixed liquid composed of an ammonium nitrate aqueous solution and calcium carbonate can be heated up to about 200°C, the above ratio may be adjusted to higher. In such a case, the concentration is more preferably not less than 10 g/L, even more preferably not less than 12 g/L, and more preferably not more than 16 g/L, even more preferably not more than 15 g/L.

The water solubility of calcium carbonate is relatively low; however, it is not necessary to completely dissolve calcium carbonate and calcium carbonate may be dispersed at this point.

### (2) First heating step

Next, the raw material mixed liquid obtained in the above step is heated at not less than 125°C.

The maximum temperature is more preferably adjusted to not less than 140°C. However, when the temperature is further increased, the result may be the same. In addition, the higher the temperature is, the higher performance closed vessel is needed. Therefore, the temperature is preferably not more than 250°C, more preferably not more than 200°C, and even more preferably not more than 180°C. However, when a closed vessel having a competent performance is used, the temperature is preferably not less than 160°C, more preferably not less than 180°C, particularly preferably not less than 190°C, and more preferably not more than 240°C, even more preferably not more than 220°C, particularly preferably not more than 210°C.

A heating means may be arbitrarily selected, and a closed vessel such as an autoclave is preferably used, since the raw material mixed liquid is heated at the boiling point or more in many cases.

In the heating step, it is preferred to stir the raw material mixed liquid in order to prevent uneven temperature. In addition, when a temperature is rapidly increased, the temperature may possibly become uneven. Therefore, it is preferred to adjust a temperature rising rate to not more than 20°C/min. On the other hand, too low temperature rising rate may be inefficient; therefore, the temperature rising rate is preferably not less than 5°C/min. In fact, the temperature may be arbitrarily adjusted depending on a size of used autoclave or the like.

In the heating step, it is important for obtaining a high quality calcite single crystal that at least fine powder among raw material calcium carbonate is completely dissolved. Therefore, it is preferred that the raw material mixed liquid is maintained at adjusted maximum temperature for 2 hours or more, depending on an amount of solvent aqueous solution, a ratio of raw material calcium carbonate or the like. On the other hand, for example, when a calcite single crystal is used as a part of raw material calcium carbonate and the raw material mixed liquid is maintained in the above condition for too long, the calcite single crystal may be completely dissolved. As a result, the effect of a calcite single crystal may not be achieved. Therefore, the maintaining time is preferably not more than 15 hours. The maintaining time is more preferably not less than 4 hours, even more preferably not less than 5 hours, and more preferably not more than 12 hours, even more preferably not more than 10 hours.

### (3) First gradually cooling step

Then, the heated raw material mixed liquid is gradually cooled. By gradually cooling the raw material mixed liquid from high temperature, a calcite crystal which is fine but of which size suitable for a stress sensor can be obtained. A cooling rate can be arbitrarily adjusted, and is not more than 10°C/h. When the cooling rate is not more than 10°C/h, a calcite single crystal which is fine but which is relatively large may be obtained more surely. However, when the cooling rate is too slow, the efficiency may be reduced. Therefore, the cooling rate is not less than 0.5°C/h. The term "cooling rate of X°C/h" means a rate to decrease temperature by X°C per 1 hour.

In the gradually cooling step, it is preferred to stir the raw material mixed liquid. The present inventors experimentally found that the size of the obtained calcite single crystal can be increased in an appropriate range by adequately controlling a stirring speed in the gradually cooling step. In more detail, the diameter of the precipitated calcite single crystal tends to be smaller in both cases that the stirring speed is too slow and too fast. On the other hand, when the stirring speed is not less than 80 r/min and not more than 300 r/min, it may be possible to increase the diameter of the calcite single crystal within an appropriate range.

The raw material mixed liquid may be cooled to ordinary temperature; however, when a second heating step described later is carried out, such a temperature may be not less than about 70°C and not more than about 120°C.

### (4) Isolating step

The obtained calcite single crystal can be isolated by an ordinary method. For example, the precipitated calcite single crystal is separated by filtration, centrifugation or the like, washed with cold water or the like, and then dried.

The particle diameter of the obtained calcite single crystal may be adjusted to an appropriate diameter for a stress sensor by classification. Such a classification can be carried out by an ordinary method such as sieving operation.

A particle diameter of the calcite single crystal as the target compound of the present invention method is preferably not less than 100 µm and not more than 1.5 mm. When the crystal having a particle diameter of not less than 100 µm is used as a stress sensor by mixing in constructional material, such a crystal may be easily found out and an interstice of a bicrystal as criteria of stress may be measured with no difficulty. In addition, when the crystal having a particle diameter of not more than 1.5 mm is used for the same purpose, the strength of a construction may not be excessively lowered. The particle diameter is more preferably not less than 150 µm, even more preferably not less than 200 µm, particularly not less than 250 µm, and more preferably not more than 1.2 mm, even more preferably not more than 1.0 mm.

When a second heating step described later is carried out, the isolating step may not be carried out and the above raw material mixed liquid obtained in the first gradually cooling step may be directly used in the second heating step.

### (5) Second heating step

The second heating step and a subsequent second gradually cooling step are carried out in order to further increase the size of the calcite single crystal which is once obtained.

In the second heating step, the mixed liquid after the above first heating step and first gradually cooling step is heated to 125°C or more again.

The conditions such as a heating rate and a maximum temperature to be set can be the same as those of the above first heating step. However, in the second heating step, among the calcite single crystal which is precipitated in the first gradually cooling step, a calcite single crystal having a relatively small particle diameter is dissolved but a calcite single crystal having a relatively large particle diameter is not completely dissolved and remained to be used as a nucleus for recrystallization; as a result, a larger crystal can be obtained. Therefore, it is preferred in the second heating step to adjust a heating rate, the maximum temperature, maintaining time and the like within the range that calcite single crystal is not completely dissolved. A specific condition may be determined by small-scale preliminarily experiment.

### (6) Second gradually cooling step

In the second gradually cooling step, the raw material mixed liquid obtained in the above second heating step is cooled and the remaining calcite single crystal is grown to produce lager crystal within an appropriate range. The specific conditions may be the same as those of the first gradually cooling step.

After the second gradually cooling step, the calcite single crystal may be isolated by carrying out the above isolating step.

According to the present invention method described in the above, a calcite single crystal which is appropriately fine can be produced in a large scale with no difficulty. In particular, a calcite single crystal which has a particle diameter of not less than 100 µm and not more than 1.5 mm can be efficiently produced.

The above calcite single crystal is useful as a stress sensor. Specifically, the calcite single crystal according to the present invention is mixed in a constructional material and the like and used for providing a construction. For example, when stress is applied to the construction by an earthquake or the like, a sample is obtained and a calcite single crystal is taken out from the sample. The maximum stress applied to the construction can be estimated by measuring an interstice of the bicrystal to which a single crystal is changed by the applied stress. In addition, a calcite single crystal having a particle diameter of not less than 100 µm can be easily found out in a sample. Therefore, it is not necessary to mix the crystal in a constructional material and the like more than necessary and strength of a construction or the like composed of the material may not decreased. Furthermore, when the particle diameter of the crystal is not more than 1.5 mm, strength of a construction or the like may not decreased similarly. Consequently, the calcite single crystal produced by the present invention method is very useful as a stress sensor, and the present invention method is also extremely useful since such a calcite single crystal can be produced by the method in a large scale with no difficulty.

The present application claims the benefit of the priority date of Japanese patent application No. 2011-25329 filed on February 8, 2011, and all of the contents of the Japanese patent application No. 2011-25329 filed on February 8, 2011, are incorporated by reference.

### EXAMPLES

Hereinafter, the present invention is described in more detail with Examples. However, the present invention is not limited by the following Examples, and the present invention can be appropriately modified to be carried out within a range which adapts to the contents of this specification. Such a modified embodiment is also included in the range of the present invention.

### Example 1: Investigation of pH

An appropriate amount of ammonia was added to 5 M ammonium nitrate aqueous solution to prepare aqueous solutions having pH of 4.74, 6.51, 7.50, 8.50, 9.40 and 10.00. A calcium carbonate powder was mixed with each solution at a concentration of 5 g/L, and then 40 mL of the solution was added into a 80 mL vessel made of Teflon (registered trademark) . The vessel was heated until the internal temperature became 160°C using a compact autoclave over 15 minutes, and maintained at 160°C for 7 hours. Next, the mixed liquid was cooled down to 20°C at a cooling rate of 5°C/h. Then, the precipitate was visually observed. In the above treatment, the mixed liquid was stirred by rotating the autoclave itself at 18 r/min.

As a result, when the pH was 9.40 or more, only too fine single crystal was precipitated and a single crystal having an appropriate size could not obtained.

In addition, when the pH was 8.50, a crystal having the maximum particle diameter of about 350 µm was obtained. However, the edge of the crystal was rounded, the crystal did not have a specific crystal face, and the transparency thereof was low.

When the pH is 6.51 or less, a single crystal could be obtained but the maximum particle diameter was small as about 200 µm and the amount thereof to be precipitated was decreased as 3.1 g.

On the other hand, when the pH was 7.50, a single crystal particle having the maximum particle diameter of about 350 µm could be obtained in a large amount. The obtained single crystal particle was separated by filtration, dried and weighted; as a result, the yield was 3.6 g and 72%.

From the above result, it was judged that the pH of the solution was preferably not less than 7.0 and not more than 8.0.

### Example 2: Investigation of concentration of ammonium nitrate aqueous solution in raw material mixed liquid

An appropriate amount of ammonia was added to each ammonium nitrate aqueous solution of 2 M, 3 M, 4 M and 5 M so that the pH was adjusted to 7.50. A calcium carbonate powder was added to each aqueous solution in a concentration of 5 g/L. The mixture was heated and then gradually cooled in the same condition as Example 1. The obtained single crystal was classified using standard sieves having apertures of 150 µm, 250 µm, 355 µm, 500 µm, 710 µm and 1000 µm, and the median diameters were measured.

As a result, the median diameters of the obtained single crystals were respectively 90 µm, 150 µm, 200 µm and 140 µm. From the data, when judged as a relative value, the excellent result was obtained in case that a concentration of an ammonium nitrate aqueous solution was not less than 3 M and not more than 5 M. However, it was found that even when the concentration of an ammonium nitrate aqueous solution was not more than 3 M, an excellent result could be obtained by adjusting the ratio of calcium carbonate powder in the raw material mixed liquid to not more than 4.5 g/L. Therefore, it was demonstrated that the concentration of ammonium nitrate in the raw material mixed liquid is preferably not less than 2 M and not more than 5 M.

### Example 3: Investigation of heating temperature

An appropriate amount of ammonia was added to 5 M ammonium nitrate aqueous solution so that the pH was adjusted to 7.50. A calcium carbonate powder was added thereto in a ratio of 5 g/L. The mixture was heated in the same condition as Example 1 with stirring at 250 r/min using an autoclave having an internal volume of 1400 mL, and then gradually cooled. As a result, the precipitated single crystal grew with adhering on the internal wall of the Teflon vessel.

Then, a similar experiment was carried out other than the maximum temperature was adjusted from 160°C to 130°C. However, a similar result was obtained.

On the other hand, when the maximum temperature was lowered to 120°C, too fine floating crystal was obtained.

From the above result, it was judged that the raw material mixed liquid should be once heated to 125°C or more.

### Example 4: Investigation of cooling rate

An appropriate amount of ammonia was added to 5 M ammonium nitrate aqueous solution so that the pH was adjusted to 7.50. A calcium carbonate powder was added thereto in a ratio of 5 g/L. Recrystallization was carried out under similar conditions to Example 1 except that the cooling rate was changed from 5°C/h to 2.5°C/h. As a result, all of product grew with adhering on the internal wall or a stirring bar, and the median diameter became 230 µm from 170 µm.

Further, when the gradually cooling rate was changed to 1°C/hr, the median diameter became 240 µm and a single crystal having a size of 500 µm or more could be also precipitated.

From the above result, it was demonstrated that the cooling rate is particularly preferably 2.5°C/h or less.

### Example 5: Investigation of stirring speed

An appropriate amount of ammonia was added to 5 M ammonium nitrate aqueous solution so that the pH was adjusted to 7.50. A calcium carbonate powder was added thereto in a ratio of 5 g/L. Recrystallization was carried out under similar conditions to Example 1 except that the stirring speed was changed to 50 r/min, 100 r/min, 250 r/min or 400 r/min.

As a result, when the stirring speed was 400 r/min, an amount of a floating single crystal was increased. The median diameters of each single crystal were 120 µm, 175 µm, 170 µm and 105 µm.

From the above result, it was judged that the stirring speed is preferably not less than 80 r/min and not more than 300 r/min.

### Example 6: Investigation of ratio of calcium carbonate powder in raw material mixed liquid

An appropriate amount of ammonia was added to 5 M ammonium nitrate aqueous solution so that the pH was adjusted to 7.50. Recrystallization was carried out under similar conditions to Example 1 except that a ratio of a calcium carbonate powder in the raw material mixed liquid was 5 g/L, 5.25 g/L, 5.5 g/L or 5.75 g/L, the maximum temperature was set to 145°C, 155°C, 165°C or 175°C, and the cooling rate was 2.5°C/h. In the above conditions, the maximum temperature was adjusted to higher as the ratio was increased so that a calcium carbonate powder was surely dissolved. The median diameters of the obtained single crystals are demonstrated in Table 1.

**[Table 1]**

| | | Ratio of calcium carbonate (g/L) | | | |
|---|---|---|---|---|---|
| | | 5.00 | 5.25 | 5.50 | 5.75 |
| Temperature | 145°C | 188 *µ*m | 212 *µ*m | | |
| | 155°C | 184 *µ*m | | 190 *µ*m | |
| | 165°C | | | 235 *µ*m | |
| | 175°C | | | 235 *µ*m | 210 *µ*m |

As the above result, when the ratio of calcium carbonate powder in the raw material mixed liquid was 5.5 g/L, the median diameter became 235 µm and an amount of single crystal having a diameter of 335 µm or more was increased.

### Example 7: Reheating treatment

When calcium carbonate single crystal is used as a stress sensor, a little larger size particle than the above-obtained particle can be used. Therefore, the condition to increase the particle diameter without being too large was investigated.

In the conditions of Example 1, the maximum temperature was set to 165°C, and the mixture was once cooled down to 110°C or 90°C at a cooling rate of 2.5°C/h and then heated up to 165°C again over 15 minutes, maintained at the same condition for 7 hours, and gradually cooled down to an ordinary temperature at a cooling rate of 2.5°C/h.

When reheating treatment was not carried out, the median diameter of calcite single crystal was 230 µm. On the other hand, when reheating treatment was carried out after gradually cooling to 110°C or 90°C, the median diameters were increased as 320 µm and 340 µm respectively. From the result, it was demonstrated that larger crystal can be obtained by once cooling the mixture after heating and then heating the mixture again. This is probably because relatively small crystal is completely dissolved by reheating but relatively large crystal remains, and the remaining crystal can grow larger due to gradually cooling from the condition.

### Example 8: Use of calcite single crystal as raw material

The inventors thought that a calcite single crystal was used as raw material in addition to a commercially available calcium carbonate powder, the condition that fine calcium carbonate powder was completely dissolved but the calcite single crystal remained at the starting time of gradually cooling was set, and gradually cooling was started at the condition.

First, an appropriate amount of ammonia was added to 5 M ammonium nitrate aqueous solution so that the pH was adjusted to 7.50. A calcium carbonate powder (5.25 g) was added to the aqueous solution (1050 mL). The ratio of calcium carbonate powder in the obtained raw material mixed liquid was 5 g/L. Recrystallization was carried out under similar conditions to Example 1 except that the raw material mixed liquid was used and the maximum temperature was set to 130°C. Further, a calcite single crystal having a diameter of 250 µm to 355 µm was used as raw material calcium carbonate in addition to commercially available calcium carbonate powder to carry out recrystallization similarly. The reason why the maximum temperature was set to 130°C was not to completely dissolve the calcite single crystal by the first heating. The used raw material calcium carbonate and the median diameters of the obtained single crystal are demonstrated in Table 2.

**[Table 2]**

| Experiment No. | Raw material CaCO₃ (ratio by mass) | | Ratio of CaCO₃ in raw material mixed | Median diameter |
|---|---|---|---|---|
| | Single crystal | Powder | | |
| 1 | 0 | 100 | 5.00 g/L | 120 *µ*m |
| 2 | 8 | 12 | 5.00 g/L | 150 *µ*m |
| 3 | 8 | 13 | 5.25 g/L | 200 *µ*m |
| 4 | 8 | 14 | 5.50 g/L | 225 *µ*m |
| 5 | 8 | 16 | 6.00 g/L | 250 *µ*m |

In the experiments of Nos. 1 and 2, many crystals were precipitated with adhering on the internal wall of the vessel. On the other hand, in the experiments of Nos. 3 to 5, most of crystals were floating. The floating crystal did not have mature crystal face, was not euhedral, and had rounded form (Figure 1). Such a crystal is suitable as a stress sensor which is mixed in a contractual material to be used. In addition, in the experiments of Nos. 3 to 5, the median diameters were increased and the experiments demonstrated the effect of the condition. From the above result, it was demonstrated that the diameter of the obtained crystal can be increased by leaving the single crystal after the first heating treatment when a calcite single crystal is used as raw material calcium carbonate and reheating treatment is carried out.

### Example 9: Investigation of heating temperature and cooling rate

An appropriate amount of ammonia was added to 5 M ammonium nitrate aqueous solution so that the pH was adjusted to 7.50. A calcium carbonate powder was added thereto in a ratio of 15 g/L. Then, 45 mL of the mixture was added into an autoclave of which internal volume was 90 mL and of which internal wall was covered with Teflon. The mixture was heated until the internal temperature became 200°C over 15 minutes and maintained at 200°C for 7 hours. Next, the mixture was cooled down to 20°C at a cooling rate of 1°C/h, 2.5°C/h or 5°C/h.

As a result, when the cooling rate was 5°C/h, the median diameter of the obtained calcite single crystal was 280 µm; and when the cooling rate was 2.5°C/h the median diameter was 345 µm. When the cooling rate was 1°C/h, the median diameter of the obtained calcite single crystal was 290 µm. Such a calcite single crystal is extremely useful as a stress sensor or the like. In addition, when heating temperature was increased, the concentration of raw material calcium carbonate could be increased and more efficient production was possible.

### Example 10: Investigation of concentration of raw material calcium carbonate

Calcite single crystal was obtained under similar conditions to Example 9 wherein the cooling rate was 2.5°C/h and except that concentration of raw material calcium carbonate was changed to 5.5 g/L, 7 g/L, 10 g/L, 15 g/L, 16 g/L or 17 g/L.

As a result, when the concentration of raw material calcium carbonate was 16 g/L or less, a calcite single crystal of which median diameter was 280 to 345 µm. In addition, the higher the concentration of raw material calcium carbonate was, the larger amount of calcite single crystal as the target compound could be understandably obtained.

On the other hand, when the concentration of raw material calcium carbonate was 17 g/L, a calcite single crystal having a diameter of not less than 250 µm which was a measurement limit value was not precipitated and the obtained crystal was fine powder. It was thought that this was probably because raw material calcium carbonate was not completely dissolved at 200°C and remained.

## Claims

1. A method for producing a calcite single crystal, comprising the steps of:
mixing raw material calcium carbonate with an ammonium nitrate aqueous solution to obtain a raw material mixed liquid, wherein pH of the ammonium nitrate aqueous solution is not less than 7.0 and not more than 8.0, a concentration of the ammonium nitrate aqueous solution is not less than 2 M, and a concentration of calcium carbonate in the raw material mixed liquid is not less than 4 g/L and not more than 16 g/L;
heating the raw material mixed liquid at not less than 125°C; and then gradually cooling the raw material mixed liquid at a cooling rate of not less than 0.5°C/h and not more than 10°C/h;
wherein the raw material mixed liquid is stirred at a stirring speed of not less than 80 r/min and not more than 300 r/min at least in the gradually cooling step.

2. The production method according to claim 1, wherein a particle diameter of the obtained calcite single crystal is not less than 100 µm and not more than 1.5 mm.

3. The production method according to claim 1 or 2, further comprising a second heating step for heating the raw material mixed liquid to not less than 125°C after the gradually cooling step, and a second gradually cooling step for gradually cooling the raw material mixed liquid after the second heating step.

4. The production method according to any one of claims 1 to 3, wherein a calcite single crystal having a particle diameter of not less than 100 µm is used as at least a part of the raw material calcium carbonate.

## Patentansprüche

1. Verfahren zur Herstellung eines Calcit-Einkristalls, umfassend die Schritte:
das Mischen des Ausgangsstoffes Calciumcarbonat mit einer wässrigen Ammoniumnitratlösung, um eine gemischte Flüssigkeit mit Ausgangsstoff zu erhalten, wobei der pH der wässrigen Ammoniumnitratlösung nicht weniger als 7,0 und nicht mehr als 8,0 beträgt, eine Konzentration der wässrigen Ammoniumnitratlösung nicht weniger als 2 M beträgt und eine Konzentration von Calciumcarbonat in der gemischten Flüssigkeit mit Ausgangsstoff nicht weniger als 4 g/L und nicht mehr als 16 g/L beträgt;
das Erwärmen der gemischten Flüssigkeit mit Ausgangsstoff bei nicht weniger als 125°C; und dann
das schrittweise Kühlen der gemischten Flüssigkeit mit Ausgangsstoff bei einer Kühlrate von nicht weniger als 0,5°C/h und nicht mehr als 10°C/h;
wobei die gemischte Flüssigkeit mit Ausgangsstoff bei einer Rührgeschwindigkeit von nicht weniger als 80 r/min und nicht mehr als 300 r/min mindestens in dem schrittweisen Kühlschritt gerührt wird.

2. Herstellungsverfahren nach Anspruch 1, wobei ein Teilchendurchmesser des erhaltenen Calcit-Einkristalls nicht weniger als 100 µm und nicht mehr als 1,5 mm beträgt.

3. Herstellungsverfahren nach Anspruch 1 oder 2, weiter umfassend einen zweiten Erwärmungsschritt für das Erwärmen der gemischten Flüssigkeit mit Ausgangsstoff auf nicht weniger als 125°C nach dem schrittweisen Kühlschritt und einen zweiten schrittweisen Kühlschritt für das schrittweise Kühlen der gemischten Flüssigkeit mit Ausgangsstoff nach dem zweiten Erwärmungsschritt.

4. Herstellungsverfahren nach einem der Ansprüche 1 bis 3, wobei ein Calcit-Einkristall mit einem Teilchendurchmesser von nicht weniger als 100 µm mindestens als ein Teil des Ausgangsstoffes Calciumcarbonat verwendet wird.

## Revendications

1. Procédé de production d'un monocristal de calcite, comprenant les étapes consistant à :
mélanger du carbonate de calcium en matière brute avec une solution aqueuse de nitrate d'ammonium pour obtenir un liquide mélangé de matière brute, dans lequel le pH de la solution aqueuse de nitrate d'ammonium n'est pas moins de 7,0 et pas plus de 8,0, une concentration en la solution aqueuse de nitrate d'ammonium n'est pas moins de 2 M, et une concentration en carbonate de calcium dans le liquide mélangé de matière brute n'est pas moins de 4 g/l et pas plus de 16 g/l;
chauffer le liquide mélangé de matière brute à pas moins de 125°C ; puis refroidir progressivement le liquide mélangé de matière brute à une vitesse de refroidissement de pas moins de 0,5°C/h et pas plus de 10°C/h ;
dans lequel le liquide mélangé de matière brute est agité à une vitesse d'agitation de pas moins de 80 tours/min et pas plus de 300 tours/min au moins dans l'étape de refroidissement progressif.

2. Procédé de production selon la revendication 1, dans lequel un diamètre particulaire du monocristal de calcite obtenu n'est pas moins de 100 µm et pas plus de 1,5 mm.

3. Procédé de production selon la revendication 1 ou 2, comprenant en outre une seconde étape de chauffage pour chauffer le liquide mélangé de matière brute à pas moins de 125°C après l'étape de refroidissement progressif, et une seconde étape de refroidissement progressif pour refroidir progressivement le liquide mélangé de matière brute après la seconde étape de chauffage.

4. Procédé de production selon l'une quelconque des revendications 1 à 3, dans lequel un monocristal de calcite ayant un diamètre particulaire de pas moins de 100 µm est utilisé comme au moins une partie du carbonate de calcium en matière brute.
